# EUROPÄISCHE PATENTANMELDUNG

(11) **EP 1 164 398 A2**
(43) Veröffentlichungstag der Anmeldung: **19.12.2001**
(21) Anmeldenummer: 01113149.7
(22) Anmeldetag: 30.05.2001
(51) Int. Cl.: G02B 7/02

(54) **Vorrichtung zur Lagerung eines optischen Elementes, z.B. einer Linse in einem Objektiv**

(30) Priorität: 17.06.2000 DE 10030004
(71) Anmelder: Carl Zeiss, 89518 Heidenheim (Brenz) (DE); Carl-Zeiss-Stiftung, trading as Carl Zeiss, 89518 Heidenheim (Brenz) (DE)
(72) Erfinder: Osterried, Karlfrid Dr., 73431 Aalen (DE); Petasch, Thomas, 73431 Aalen (DE)
(74) Vertreter: Lorenz, Werner

(57) **Zusammenfassung**

Eine Vorrichtung zur Lagerung eines optischen Elementes (1), z.B. einer Linse in einem Objektiv, insbesondere in einem Belichtungsobjektiv (2) in der Halbleiter-Lithographie, ist mit folgenden Merkmalen versehen: das optische Element (1) ist in seinem Randbereich mit Auflagestellen (8,9,10) versehen. Den Auflagestellen (8,9,10) des optischen Elementes (1) gegenüberliegend sind in einer Außenfassung (3) Gegenlagerstellen (11) angeordnet. Zwischen den Auflagestellen (8,9,10) und den Gegenlagerstellen (11) sind Lagerkörper (12) angeordnet. Die Lagerkörper (12) sind mit zu den Auflagestellen (8,9,10) gerichteten kugelförmigen Oberflächen versehen.

## Beschreibung

Die Erfindung betrifft eine Vorrichtung zur Lagerung eines optischen Elementes, z.B. einer Linse in einem Objektiv, insbesondere in einem Belichtungsobjektiv in der Halbleiter-Lithographie.

Optische Elemente, insbesondere Linsen, sind im allgemeinen in einer sogenannten Richtklebefassung bzw. Innenfassung gelagert, welche wiederum mit einer Außenfassung verbunden ist. Durch die Richtklebefassung können mechanische Verspannungen auf das optische Element aufgebracht werden, die die Abbildungsgenauigkeit des optischen Elementes beeinträchtigen. In Objektiven für die Halbleiter-Lithographie sind sogenannte Korrekturelemente, z.B. Linsen, bekannt, welche zum Austausch in einem Objektiv vorgesehen sind, um optische Restfehler zu bearbeiten bzw. auszuschalten.

Bei einem Austausch eines optischen Elementes, z.B. einer Korrekturlinse, und einem anschließenden Wiedereinbau oder einem Einbau eines anderen optischen Elementes, können sich neue Fehler einschleichen, insbesondere Einbaufehler.

Darüber hinaus ist es häufig erforderlich, optische Elemente, insbesondere Linsen, die sich auf einem Richtklebeplatz für eine Montage befinden, mit ihren optischen Achsen senkrecht zu der Fassung des Objektives auszurichten.

Der vorliegenden Erfindung liegt daher die Aufgabe zugrunde, eine Vorrichtung der eingangs erwähnten Art zu schaffen, die keine Verspannungen auf das optische Element aufbringt und bei der auch gesichert ist, daß bei einem Austausch des optischen Elementes und bei einem erneuten Einbau keine neuen Fehler auftauchen bzw. daß dabei ein reproduzierbarer Wiedereinbau erreicht wird.

Der Erfindung liegt weiterhin die Aufgabe zugrunde, gleichzeitig auch eine Kipp-Justage bzw. ein exaktes Einjustieren des optischen Elementes bei der Montage oder nach einem Ausbau und einem erneuten Einbau vorzusehen.

Erfindungsgemäß wird diese Aufgabe durch die in Anspruch 1 genannten Merkmale gelöst.

Erfindungsgemäß übernimmt nunmehr das optische Element gleichzeitig die Funktion einer Innenfassung bzw. ist diese in das optische Element integriert. Hierzu ist es lediglich erforderlich, einen entsprechenden Randbereich mit Auflagestellen vorzusehen, wozu im allgemeinen lediglich der Durchmesser des optischen Elementes geringfügig vergrößert werden muß.

Durch die präzise Zuordnung der Auflagestellen und der Gegenlagerstellen wird nicht nur eine Reproduzierbarkeit beim Ein- und Ausbau erreicht, sondern darüber hinaus entfallen aufgrund fehlender Richtklebeverbindungsstellen auch mechanische Verspannungen.

In einer vorteilhaften Ausgestaltung der Erfindung kann dabei vorgesehen sein, daß der Randbereich des optischen Elementes mit den Auflagestellen wenigstens annähernd eine ebene Fläche bildet, womit eine gute Reproduzierbarkeit erreicht werden kann.

In einer sehr vorteilhaften Ausgestaltung der Erfindung kann vorgesehen sein, daß die Auflagestellen, die Gegenlagerstellen und die Lagerkörper ein Drei-Punkt-Lager bilden mit einer flächigen Auflage, einer rinnenförmigen Auflage und einer Fixpunktauflage.

In einer sehr vorteilhaften Ausgestaltung der Erfindung kann vorgesehen sein, daß zur Einstellung einer Kipp-Justage bei der Montage die Auflagestellen, die z.B. durch V-förmige Rinnen oder Nuten gebildet sind, in einem Winkel zu einer rechtwinklig zur z-Achse liegenden Ebene liegen. Im allgemeinen stellt dies die horizontale Ebene dar. Auf diese Weise ergibt sich neben dem Effekt einer besseren Zentrierung des optischen Elementes die Möglichkeit, durch ein einfaches laterales Verschieben der Auflagepunkte (einer oder mehrerer) in radialer Richtung, eine Höhenänderung des optischen Elementes an diesem Punkt zu erreichen, womit durch eine Höhenänderung der Auflagepunkte an dem optischen Element dessen Kippung erreicht wird. Über die Wahl des Neigungswinkels kann die Auflösung eingestellt werden, wodurch die Kippung auf sehr kleine Werte auskorrigiert werden kann.

Das vorstehende Justageverfahren kann im Bedarfsfalle bereits bei der Montage angewendet werden, wobei keine Demontage der Auflagefüßchen erforderlich ist. Auf diese Weise erhält man eine entsprechende Zeitersparnis.

In einer anderen Ausgestaltung kann vorgesehen sein, daß die Auflagestellen durch V-förmige Rinnen oder Nuten gebildet sind, wobei die Längswände der Rinnen bzw. Nuten unter einem Winkel zueinander liegen.

Normalerweise verlaufen die Nutwände parallel zueinander. Ordnet man diese erfindungsgemäß nunmehr unter einem Winkel zueinander an, so kann durch ein radiales Verschieben eines Auflagepunktes ebenfalls eine Kippung des optischen Elementes erzeugt werden. Durch ein entsprechendes Verschieben ändert sich die Eintauchtiefe der Lagerkörper und somit die z-Höhe der Auflagestelle.

Wenn in einer alternativen Lösung die Gegenlagerstellen, an denen die Lagerkörper angeordnet sind, unter einem Winkel zu einer rechtwinklig zur z-Achse liegenden Ebene liegen, im allgemeinen zur horizontalen Ebene, dann ändert sich durch ein radiales Verschieben der Auflagestellen auf der schrägen Fassung ebenfalls die Höhenlage des Auflagepunktes des Lagerkörpers an dem optischen Element entsprechend. Auf diese Weise wird ebenfalls eine Kippung erzeugt. Über den Winkel kann dann die Auflösung eingestellt werden. Selbstverständlich ist der gleiche Winkel dann an der Außenfassung vorzusehen.

Vorteilhafte Weiterbildungen und Ausgestaltungen ergeben sich aus den übrigen Unteransprüchen und aus den nachfolgend anhand der Zeichnung beschriebenen Ausführungsbeispielen.

### Es zeigt:

- Figur 1: eine Seitenansicht der erfindungsgemäßen Vorrichtung;
- Figur 1a: einen Ausschnitt aus der Figur 1 mit einer in anderer Ausgestaltung einer Sicherungseinrichtung;
- Figur 2: eine Draufsicht auf das optische Element nach der Figur 1 in verkleinerter Darstellung;
- Figur 3: eine Seitenansicht eines optischen Elementes, nämlich einer Linse, in einer erhabenen bzw. konvexen Ausbildung mit der erfindungsgemäßen Ausgestaltung;
- Figur 4: eine Seitenansicht eines optischen Elementes, nämlich einer Linse, in einer erhabenen bzw. konvexen Ausbildung mit der erfindungsgemäßen Ausgestaltung, wobei Auflagestellen direkt in die Linsenfläche eingearbeitet sind;
- Figur 5: eine Linse in einer konkaven Ausbildung in einer erfindungsgemäßen Ausgestaltung mit Auflagefläche; und
- Figur 6: eine Seitenansicht einer Vorrichtung für eine Kipp-Justage mit unter einem Winkel α zur horizontalen Ebene geneigten V-förmigen Nuten;
- Figur 7: eine Ansicht eines optischen Elementes von unten her für eine Kipp-Justage anderer Ausgestaltung;
- Figur 8: ausschnittsweise eine Seitenansicht der Kipp-Justage nach der Fig. 7, teilweise im Schnitt; und
- Figur 9: ausschnittsweise eine Seitenansicht für eine Kipp-Justage mittels einer schrägen Fassung.

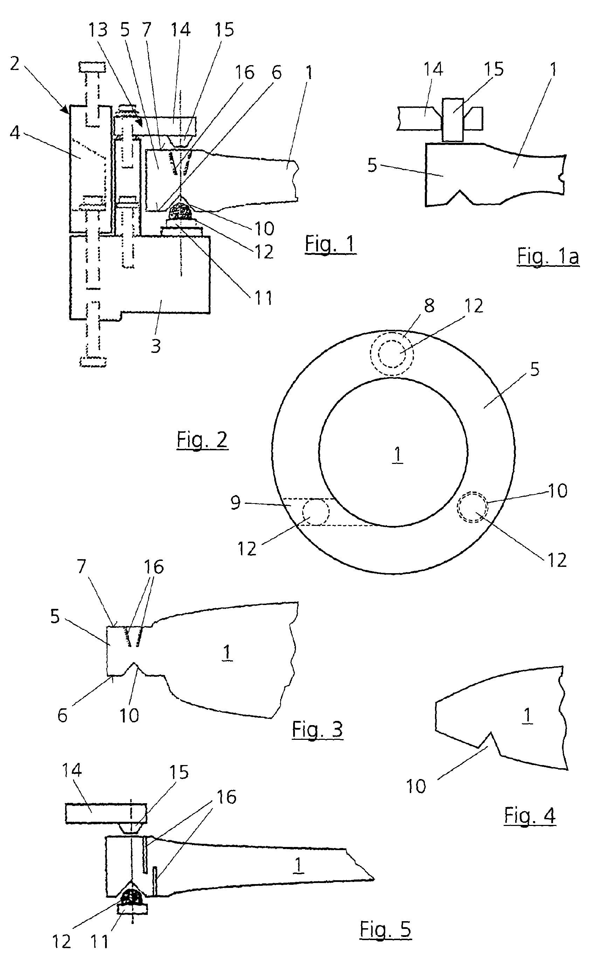

Bei den nachfolgenden Ausführungsbeispielen wird eine Linse 1, z.B. eine Korrekturlinse, als optisches Element zur Erläuterung der erfindungsgemäßen Vorrichtung verwendet. Selbstverständlich ist die Vorrichtung jedoch auch noch für andere optische Elemente verwendbar, wie z.B. planoptische Platten, Prismen oder Elemente, die z.B. die Polarisation oder Intensitätsverteilung beeinflußen. Ein bevorzugtes Anwendungsgebiet ist dabei ein Belichtungsobjektiv 2 in der Halbleiter-Lithographie. Dargestellt ist zur Vereinfachung in der Figur 1 nur ein Belichtungsobjektiv 2 ausschnittsweise mit einer Außenfassung 3 und einem damit verbundenen Abstimmring 4. Der Abstimmring 4 ist wiederum über Schrauben mit einer darüber angeordneten Außenfassung (nicht dargestellt) verbunden.

Die Linse 1 ist mit einem erweiterten Randbereich 5 versehen, welcher auf seiner Unterseite 6 und auf seiner Oberseite 7 eine ebene Fläche aufweist. In der unteren ebenen Fläche 6 sind über den Umfang verteilt drei Auflagestellen vorgesehen, nämlich eine flächige Auflage 8, eine rinnenförmige Auflage 9 und eine Fixpunktauflage 10. Die Fixpunktauflage 10 ist durch eine kegelförmige Aussparung gebildet, wie dies aus der Figur 1 ersichtlich ist.

In der Außenfassung 3 sind entsprechend zugeordnet drei Gegenlagerstellen 11 vorgesehen, die mit Lagerkörpern 12 versehen sind, welche als Kugeln ausgebildet sind oder zumindest jeweils eine zu den Auflagestellen 8, 9 und 10 gerichtete kugelförmige Oberfläche aufweisen.

Wie aus den Figuren 1 und 2 ersichtlich ist, wird auf diese Weise ein Drei-Punkt-Lager gebildet, wodurch die Linse 1 exakt positioniert ist, womit sie auch nach einer erfolgten Demontage wieder exakt und damit reproduzierbar eingesetzt werden kann.

Wie aus der Figur 2 ersichtlich ist, läuft die Verlängerung der Längsachse der rinnenförmigen Auflage 9 durch die Fixpunktauflage 10, welche durch ein kegelförmiges Aufnahmeteil (Figur 1) gebildet ist. Auf diese Weise wird eine sehr genaue Reproduzierbarkeit der Auflage erreicht.

Eine hohe Lagerreproduzierbarkeit kann durch die Verwendung von Hartmetallelementen erreicht werden.

In der Regel werden Objektive in der Halbleiter-Lithographie nicht gekippt und fallen auch nicht um. Aus diesem Grund wäre an sich keine besondere Fixierung erforderlich. Aus Sicherheitsgründen kann man jedoch zusätzlich noch eine Sicherungseinrichtung 13 vorsehen, die gegen ein grobes Verschieben oder ein Herausfallen der Linse 1 vorgesehen ist. Wichtig ist dabei jedoch, daß durch die Sicherungseinrichtung 13 keine Kräfteübertragung auf das optische Element 1, in diesem Falle auf die Linse, stattfindet. Dies kann z.B. durch einen Luftspalt von einigen um oder durch eine Klebeschicht erfolgen, die jedoch keinen Druck ausüben darf. Zu diesem Zweck ist die Sicherungseinrichtung 13 mit einem Ausleger 14 versehen, aus welchem ein Sicherungsglied 15 in Richtung auf die obere ebene Fläche 7 der Linse 1 gerichtet ist.

Zur genauen Abstandseinstellung und zum Erreichen einer Kräftefreiheit ist das Sicherungsglied 15 in Richtung der z-Achse bzw. der optischen Achse verstellbar. Als Sicherungsglied 15 sind z.B. kegelförmige, stumpfkegelförmige, kugelförmige oder auch zylindrische Körper möglich. In der Figur 1a ist ein zylindrischer Körper als Sicherungsglied 15 dargestellt, das beweglich in Richtung auf die Linse 1 ist und das nach einer genauen Abstandseinstellung, z.B. durch eine Schraube oder durch Kleber dann an dem Ausleger 14 fixiert wird.

Zum Entkoppeln des Nutzbereiches der Linse 1 von mechanischen Spannungen, die z.B. aus der Verklebung mit der Sicherungseinrichtung 13 oder aus thermischen Ausdehnungsdifferenzen zwischen der Linse 1 und der Sicherungseinrichtung 13 resultieren, können Freistiche 16 in die obere ebene Fläche 7 und/oder in die untere ebene Fläche 6 eingebracht sein. Die Freistiche 16 sind, wie ersichtlich, im Randbereich vorgesehen, wobei es im allgemeinen ausreichend ist, wenn sich diese nur in den Umfangsabschnitten befinden, in denen sich die Auflagestellen 8, 9 und 10 befinden. Die Freistiche 16 können in vertikaler Richtung oder auch schräg bzw. geneigt zur z-Achse verlaufen.

Aus der Figur 3 sind zwei schräg verlaufende Freistiche 16 in der oberen ebenen Fläche 7 und aus der Figur 4 ein Freistich in der oberen Fläche 7 und ein weiterer vertikaler Freistich in der unteren ebenen Fläche 6 ersichtlich. Wie ersichtlich, sind die Freistiche gemäß Figur 3 konzentrisch als Kegelmantellinie ausgebildet.

Anzumerken ist auch noch, daß die Randbereiche nicht unbedingt eben verlaufen müssen, sondern im Bedarfsfall auch geneigt sein können.

Die obere ebene Fläche 7 des Randbereiches 5 wird auf eine geringe Mikrorauhigkeit feingeläppt, um eine mechanisch meßbare Oberfläche für die Justage des horizontalen Auslegers 14 bzw. des Sicherungsgliedes 15 zu gewährleisten.

Die Auflagestellen 8, 9 und 10 können bereits im Rahmen der Vorpolitur der Nutzfläche des optischen Elementes 1 eingefräst und spiegelnd poliert werden.

Wie ersichtlich, besitzt das optische Element 1 keine Fassung mehr, sondern stellt eine lose Linse dar, welche z.B. als Korrekturelement bzw. Korrekturlinse in einfacher Weise entfernt werden kann.

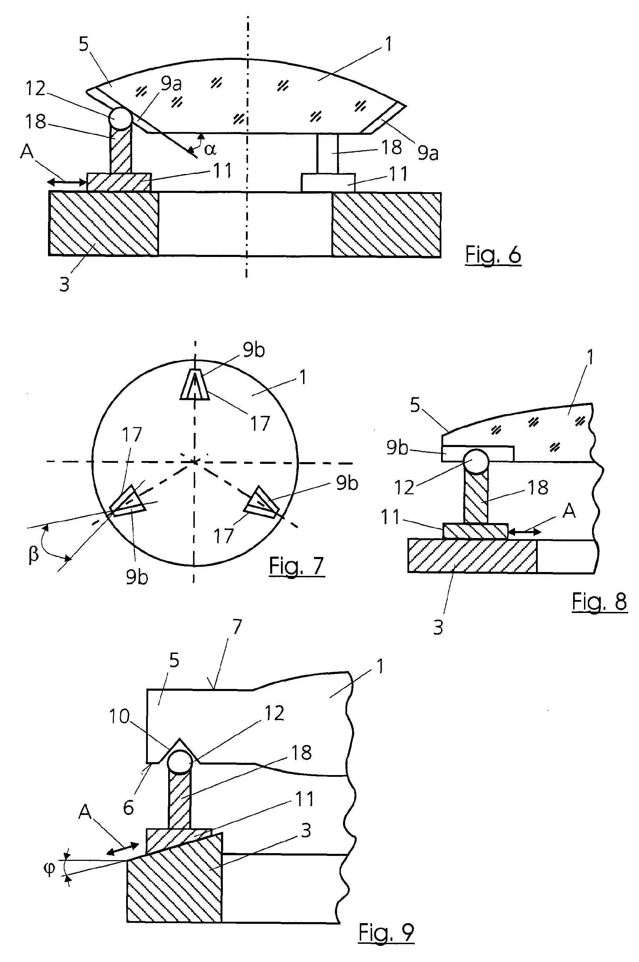

Die Figur 6 zeigt eine Vorrichtung für eine erste Ausführungsform bezüglich einer Kipp-Justage. In diesem Falle sind drei um 120° versetzt zueinander angeordnete V-förmige Nuten 9a in der Linse 1, radial angeordnet, vorgesehen, die unter dem Winkel α zur z-Achse geneigt sind. Bei dieser Anordnung ist die Neigung somit schräg zur horizontalen Ebene gerichtet. Damit erreicht man auch eine optimale Zentrierung der Linse 1. Durch ein einzelnes Verschieben einer Gegenlagerstelle 11 in Pfeilrichtung A läßt sich durch eine daraus resultierende entsprechende Verschiebung des Lagerkörpers 12 in der Rinne bzw. die Nut 9a eine Kippung einstellen. Die auf diese Weise erreichte Höhenänderung des Auflagepunktes für die Linse 1 bedeutet eine Kippung der Linse 1. Je flacher der Neigungswinkel α ist, desto präziser und feinfühliger läßt sich die Kippung einstellen. Gegebenenfalls kann auch das optische Element, nämlich die Linse 1, gegenüber den Auflagepunkten verschoben werden, womit ebenfalls Kippungen eingestellt werden, wobei sich allerdings die Zentrierung ändert.

In den Figuren 7 und 8 ist eine andere Ausgestaltung für eine Kipp-Justage dargestellt. Wie aus der Figur 7 ersichtlich ist, verlaufen dabei die Längswände 17 der V-förmigen Nuten 9b nicht parallel zueinander, sondern sind unter einem Winkel β zueinander angeordnet. Durch ein radiales Verschieben in Pfeilrichtung A der Gegenlagerstelle 11 oder auch der Linse 1 ändert sich somit die Eintauchtiefe des Lagerkörpers 12 in die jeweilige V-förmige Nut 9b, womit sich eine Höhenänderung des entsprechenden Auflagepunktes und damit eine Kippung des optischen Elementes, nämlich der Linse 1, einstellt.

Figur 9 zeigt eine Kipp-Justage, wobei die Gegenlagerstellen 11, auf denen die Lagerkörper 12 angeordnet sind, unter einem Winkel ϕ zu der rechtwinklig zur z-Achse liegenden Ebene, welche im vorliegenden Falle die Horizontalebene darstellt, liegen. Selbstverständlich ist es in diesem Falle erforderlich, daß auch die Bereich der Außenfassung 3, die sich unter den Gegenlagerstellen 11 befinden, den gleichen Winkel aufweisen.

Durch ein radiales Verschieben der Gegenlagerstellen 11 in Pfeilrichtung A auf der Schräge, wird ebenfalls eine entsprechende Höhenänderung und damit eine Kipp-Justage der Auflagepunkte der Linse 1 auf den Lagerkörpern 12 erreicht.

Bei den Ausführungsbeispielen nach den Figuren 6 bis 9 sind die Lagerkörper 12 jeweils über einen Zwischensteg 18 mit den Gegenlagerstellen 11 verbunden. Selbstverständlich kann die Lagerung der Lagerkörper 12 auf den Gegenlagerstellen 11 auch auf andere Weise erfolgen, wozu z.B. auf die Figuren 1 bis 5 verwiesen wird.

## Patentansprüche

1. Vorrichtung zur Lagerung eines optischen Elementes, z.B. einer Linse in einem Objektiv, insbesondere in einem Belichtungsobjektiv in der Halbleiter-Lithographie, mit folgenden Merkmalen:
a) das optische Element (1) ist in seinem Randbereich mit Auflagestellen (8,9,10) versehen,
b) den Auflagestellen (8,9,10) des optischen Elementes (1) gegenüberliegend sind in einer Außenfassung (3) Gegenlagerstellen (11) angeordnet,
c) zwischen den Auflagestellen (8,9,10) und den Gegenlagerstellen (11) sind Lagerkörper (12) angeordnet, und
d) die Lagerkörper (12) sind mit zu den Auflagestellen (8,9,10) gerichteten kugelförmigen Oberflächen versehen.

2. Vorrichtung nach Anspruch 1, **dadurch gekennzeichnet, daß** der Randbereich des optischen Elementes (1) mit den Auflagestellen (8,9,10) wenigstens annähernd eine ebene Fläche aufweist.

3. Vorrichtung nach Anspruch 1 oder 2, **dadurch gekennzeichnet, daß** die Auflagestellen (8,9,10), die Gegenlagerstellen (11) und die Lagerkörper (12) ein Drei-Punkt-Lager bilden mit einer flächigen Auflage (8), einer rinnenförmigen Auflage (9) und einer Fixpunktauflage (10).

4. Vorrichtung nach Anspruch 3, **dadurch gekennzeichnet, daß** die Verlängerung der Längsachse der rinnenförmigen Auflage (9) durch die Fixpunktauflage (10) verläuft, welche durch ein kegelförmiges Aufnahmeteil gebildet ist.

5. Vorrichtung nach Anspruch 1, 3 oder 4, **dadurch gekennzeichnet, daß** das optische Element (1) im Randbereich mit Freistichen (16) zur Entkoppelung des Nutzbereiches des optischen Elementes (1) von mechanischen Spannungen versehen ist.

6. Vorrichtung nach einem der Ansprüche 1 bis 5, **dadurch gekennzeichnet, daß** auf der den Auflagestellen (8,9,10) gegenüberliegenden Seite des optischen Elements (1) eine Sicherungseinrichtung (13) für eine Sicherung in z-Richtung vorgesehen ist.

7. Vorrichtung nach Anspruch 6, **dadurch gekennzeichnet, daß** die Sicherungseinrichtung (13) über eine Klebeverbindung mit dem optischen Element (1) verbunden ist.

8. Vorrichtung nach Anspruch 6 oder 7, **dadurch gekennzeichnet, daß** die Sicherungseinrichtung (13) bezüglich ihrer thermischen Ausdehnung an die thermische Ausdehnung des optischen Elementes (1) angepaßt ist.

9. Vorrichtung nach Anspruch 8, **dadurch gekennzeichnet, daß** die Sicherungseinrichtung (13) mit einem Sicherungsglied (15) versehen ist, das gegenüber dem optischen Element (1) einstellbar ist.

10. Vorrichtung nach einem der Ansprüche 1 bis 8, **dadurch gekennzeichnet, daß** die Oberseite des Randbereiches (5) des optischen Elementes (1) auf Mikrorauhigkeit feingeläppt ist.

11. Vorrichtung nach einem der Ansprüche 1 bis 10, **dadurch gekennzeichnet, daß** das optische Element (1) eine Korrekturlinse in einem Belichtungsobjektiv (2) in der Halbleiter-Lithographie ist.

12. Vorrichtung nach Anspruch 1, **dadurch gekennzeichnet, daß** die Auflagestellen (9a) in einem Winkel α zu einer rechtwinklig zur z-Achse liegenden Ebene liegen.

13. Vorrichtung nach Anspruch 12, **dadurch gekennzeichnet, daß** die Auflagestellen durch V-förmige Rinnen oder Nuten (9a) gebildet sind, deren Längsachsen zur z-Achse gerichtet sind.

14. Vorrichtung nach Anspruch 1, **dadurch gekennzeichnet, daß** die Auflagestellen durch V-förmige Rinnen oder Nuten (9b) gebildet sind, wobei die Längswände der Rinnen bzw. Nuten (17) unter einem Winkel β zueinander liegen.

15. Vorrichtung nach Anspruch 1, **dadurch gekennzeichnet, daß** die Gegenlagerstellen (11), mit denen die Lagerkörper (12) verbunden sind, unter einem Winkel ϕ zu einer rechtwinklig zur z-Achse liegenden Ebene liegen.

16. Vorrichtung nach Anspruch 15, **dadurch gekennzeichnet, daß** die der Außenfassung (3) zugewandten Seiten der Gegenlagerstellen (11) zur z-Achse schräg verlaufen und daß die Außenfassung (3) zumindest in den Bereichen, auf denen die Gegenlagerstellen (11) aufliegen, die gleiche Schräge aufweisen.

17. Vorrichtung nach einem der Ansprüche 12 bis 16, **dadurch gekennzeichnet, daß** die Gegenlagerstellen (11) in radialer Richtung verschiebbar sind.
